# EUROPEAN PATENT SPECIFICATION

(11) **EP 3 674 845 B1**
(45) Date of publication and mention of the grant of the patent: **04.05.2022**
(21) Application number: 19219831.5
(22) Date of filing: 27.12.2019
(51) Int. Cl.: G06F 1/28, G06F 1/30, G06F 11/30, G06F 11/07, B60W 50/04

(54) **CONTROLLER FOR DRIVERLESS VEHICLE, AND DRIVERLESS VEHICLE**
STEUERGERÄT FÜR FAHRERLOSES FAHRZEUG UND FAHRERLOSES FAHRZEUG
ORGANE DE COMMANDE DE VÉHICULE SANS PILOTE ET VÉHICULE SANS PILOTE

(30) Priority: 29.12.2018 CN 201811646749
(43) Date of publication of application: 01.07.2020
(73) Proprietor: Apollo Intelligent Driving Technology (Beijing) Co., Ltd., Haidian District Beijing 100085 (CN)
(72) Inventor: LI, Yuanfeng, Haidian District, Beijing 100085 (CN)
(74) Representative: Zimmermann, Tankred Klaus

(56) References cited:
- EP-A1- 3 153 970
- CN-U- 204 631 501
- US-A1- 2005 251 308
- US-A1- 2018 107 212

## Description

### TECHNICAL FIELD

The present disclosure relates to the field of driverless technologies, and more particularly, to a controller for a driverless vehicle, and a driverless vehicle.

### BACKGROUND

In the related art, the controller for the driverless vehicle has a low level of safety and poor safety monitoring for its hardware, resulting in low safety and reliability, which is difficult to meet high hardware safety requirements of international functional safety standard ISO 26262.

Patent CN204631501U discloses a vehicle control unit based on two MPUs.

Patent US2018107212A1 discloses a method of processing data for an automated vehicle.

Patent EP3153970A1 discloses a vehicle safety electronic control system.

Patent US2005251308A1 discloses a method and device for controlling the functional unit of a motor vehicle.

### SUMMARY

It is an object of the present invention to provide a controller for a driverless vehicle and a driverless vehicle including the same which provide an increased level of safety and an improved safety monitoring for its hardware, resulting in high safety and reliability,

This object is achieved by a controller according to claim 1, and by a driverless vehicle according to claim 12.

In a first aspect, embodiments of the invention provide a controller for a driverless vehicle, including a security micro control unit and a processor module. The processor module is coupled to the security micro control unit. The security micro control unit is configured to monitor a running state of the processor module. The controller further includes a power management module. The power management module is coupled to the security micro control unit, and configured to monitor the running state of the secure micro control unit. The security micro control unit is configured to monitor the running state of the power management module.

Optionally, the processor module includes a first processor and a second processor, and the first processor and the second processor are coupled to the security micro control unit respectively. The security micro control unit is configured to monitor a running state of each of the first processor and the second processor.

Optionally, the controller includes a power supply and a processor power supply subsystem. The processor power supply subsystem is coupled to the power supply and the processor module, and configured to provide an operating voltage to the processor module based on a power supply voltage output by the power supply. The security micro control unit is coupled to the processor power supply subsystem, and configured to monitor a running state of the processor power supply subsystem.

Optionally, the controller includes an emergency power supply subsystem. The emergency power supply subsystem is coupled to the power supply and the power management module, and the power supply is coupled to the power management module. The emergency power supply subsystem is configured to provide a power supply voltage to the power management module based on a pre-stored power quantity when the power supply fails. The power management module is configured to provide an operating voltage to the security micro control unit based on the power supply voltage output by the power supply when the power supply does not fail, and to provide the operating voltage to the security micro control unit based on a power supply voltage output by the emergency power supply subsystem when the power supply fails. The security micro control unit is configured to monitor the running state of each of the first processor and the second processor based on the operating voltage provided by the power management module, and to start a standby controller when the first processor or the second processor fails.

Optionally, the power supply includes a power source, a main power supply circuit, and a standby power supply circuit. An input end of the main power supply circuit and an input end of the standby power supply circuit are coupled to the power source respectively, and an output end of the main power supply circuit is coupled to a joint node. An output end of the standby power supply circuit is coupled to the joint node through a switching component. The joint node is coupled to the processor power supply subsystem and the emergency power supply subsystem. The switching component is configured to switch on a connection between the standby power supply circuit and the joint node when the main power supply circuit fails.

Optionally, the switching component includes a first diode, the output end of the standby power supply circuit is coupled to an anode of the first diode, and a cathode of the first diode is coupled to the joint node.

Optionally, the main power supply circuit includes a first connector, a first electrostatic protection circuit, a first interruption detection circuit, and an anti-reverse protection circuit. An input end of the first connector is coupled to the power source. The first electrostatic protection circuit and the first interruption detection circuit are coupled to an output end of the first connector, respectively. The anti-reverse protection circuit is coupled to the first electrostatic protection circuit, and the anti-reverse protection circuit is further coupled to the joint node. The security micro control unit is coupled to the first interruption detection circuit, and configured to monitor a running state of the first interruption detection circuit.

Optionally, the standby power supply circuit includes a second connector, a second electrostatic protection circuit, and a second interruption detection circuit. An input end of the second connector is coupled to the power source. The second electrostatic protection circuit is coupled to an output end of the second connector, the anode of the first diode is coupled to the second electrostatic protection circuit, and the second interruption detection circuit is coupled to the cathode of the first diode. The security micro control unit is coupled to the second interruption detection circuit, and configured to monitor a running state of the second interruption detection circuit.

Optionally, the power supply includes a voltage filtering circuit. An input end of the voltage filtering circuit is coupled to the joint node, and an output end of the voltage filtering circuit is coupled to the processor power supply subsystem, the emergency power supply subsystem, and the power management module.

Optionally, the power management module includes a security channel signal source.

The security channel signal source is coupled to the security micro control unit and a standby controller. The power management module is configured to trigger the security channel signal source to send a security channel signal to the standby controller to start the standby controller when monitoring that a security fault occurs in the security micro control unit. The security micro control unit is configured to trigger the security channel signal source to send a security channel signal to the standby controller to start the standby controller when monitoring that the security fault occurs in the first processor or the second processor.

Optionally, the power management module includes a power management integrated circuit (PMIC).The first processor includes a field programmable gate arrays (FPGA), and the second processor includes the FPGA.

In a second aspect, embodiments of the invention provide a driverless vehicle, which includes the above controller.

Optionally, the driverless vehicle includes a camera module, a motion measurement module, an Ethernet communication module, a controller area network (CAN) communication module, and a heat dissipation module. The camera module, the motion measurement module, the Ethernet communication module, the CAN communication module and the heat dissipation module are coupled to the security micro control unit. The security micro control unit is configured to monitor a running state of each of the camera module, the motion measurement module, the Ethernet communication module, the CAN communication module, and the heat dissipation module.

Optionally, the driverless vehicle includes a vehicle speed signal acquisition circuit, a steering wheel angle signal acquisition circuit, a brake signal acquisition circuit, and a gear signal acquisition circuit. The vehicle speed signal acquisition circuit, the steering wheel angle signal acquisition circuit, the brake signal acquisition circuit and the gear signal acquisition circuit are coupled to the security micro control unit. The security micro control unit is configured to monitor a running state of each of the vehicle speed signal acquisition circuit, the steering wheel angle signal acquisition circuit, the brake signal acquisition circuit, the gear signal acquisition circuit.

With the controller for a driverless vehicle and the driverless vehicle according to embodiments of the invention, the controller includes a security micro control unit and a processor module, the processor module is coupled to the security micro control unit, and the security micro control unit is configured to monitor the running state of the processor module, the safety and reliability of the controller for the driverless vehicle can be greatly improved.

### BRIEF DESCRIPTION OF THE DRAWINGS

The accompanying drawings, which are incorporated in and constitute a part of the specification, illustrate embodiments consistent with the present invention and, together with the description, serve to explain the principles of the present invention . These and other aspects and advantages of embodiments of the present invention will become apparent and more readily appreciated from the following descriptions made with reference to the accompanying drawings, in which:
FIG. 1 is a schematic diagram a controller for a driverless vehicle according to an embodiment .
FIG. 2 is a schematic diagram of a controller for a driverless vehicle according to another embodiment.
FIG. 3 is a schematic diagram of a power supply according to an embodiment
FIG. 4 is a schematic diagram a driverless vehicle according to an embodiment

### DETAILED DESCRIPTION

In order to enable those skilled in the art to better understand the technical solution of the present invention, the controller for the driverless vehicle, and the driverless vehicle according to an embodiment of the present invention will be described in detail below with reference to the accompanying drawings. The present invention will be described in detail below with reference to the accompanying drawings. Although certain embodiments of the present invention are shown in the drawings, the present invention may be implemented in various forms, and should not be construed as being limited to the embodiments set forth herein. Instead, the embodiments are provided to provide a more complete and clear understanding of the present invention, the drawings and embodiments of the present invention are for illustrative purpose only and are not intended to limit the scope of the present invention.

The term "and/or" used herein includes any and all combinations of one or more of the associated listed items. The terms used herein are for the purpose of describing embodiments, and are not intended to limit the present disclosure. When the terms "including" and "made of' are used in the present specification, it is specified that the described features, integers, steps, operations, elements and/or components are present, and the presence or addition of one or more other features, integers, steps, operations, elements, components, and/or groups thereof is not excluded.

Embodiments described herein may be described with reference to a plan view and/or a cross-sectional view, by way of the schematic diagram of the present invention. Accordingly, the exemplary diagrams may be modified in accordance with manufacturing techniques and/or tolerances. Therefore, the present invention is not limit to the embodiments shown in the drawings, modifications of the configurations formed based on the manufacturing process may also be included. Accordingly, the regions illustrated in the drawings have illustrative attributes, and the shapes of the regions illustrated in the drawings illustrate the specific shapes of the regions of the elements, and are not intended to be limiting.

All terms (including technical and scientific terms) used herein have the same meaning as commonly understood by those skilled in the art, unless otherwise defined. It will also be understood that those terms such as those defined in commonly used dictionaries should be interpreted as having the meaning consistent with their meaning in the context of the related art and the present disclosure, and will not be construed as having an idealized or excessively formal meaning, unless specifically defined herein.

In the driverless vehicles, the controllers/systems usually have capabilities, such as environment perception, intelligent networking, path planning and vehicle control.

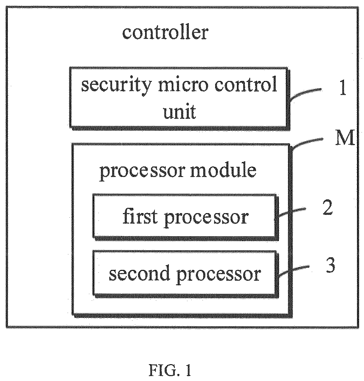

FIG. 1 is a schematic diagram a controller for a driverless vehicle according to an embodiment of the present invention. As illustrated in Fig. 1, the controller includes a security micro control unit 1 and a processor module M. The processor module M includes a first processor 2 and a second processor 3.

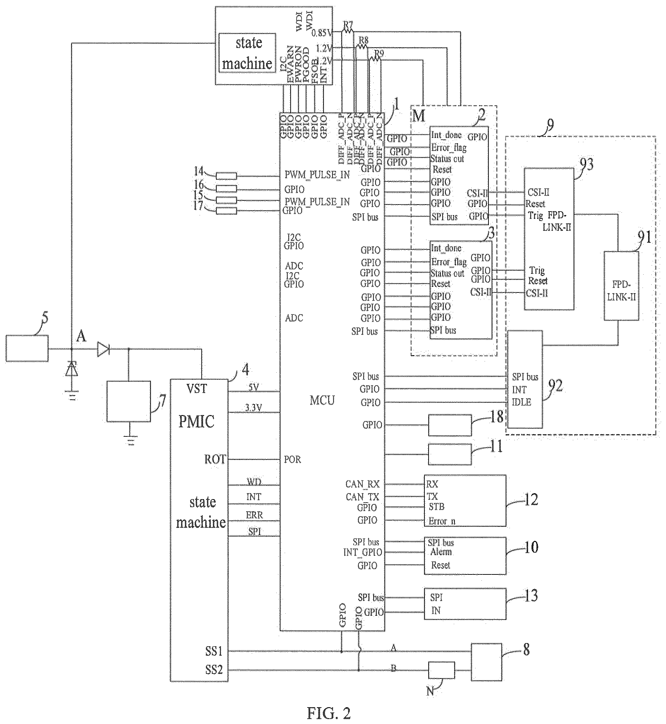

FIG. 2 is a schematic diagram of a controller for a driverless vehicle according to an embodiment of the present invention. . As illustrated in Fig. 2, the controller ACU may include a security micro control unit 1 and a processor module M. The processor module M is coupled to the security micro control unit 1, and the security micro control unit 1 is configured to monitor a running state of the processor module M. In an example, the controller may be a control chip.

In some embodiments, the processor module M includes a first processor 2 and a second processor 3, the first processor 2 and the second processor 3 are coupled to the security micro control unit 1 respectively. The security micro control unit 1 is configured to monitor the running state of each of the first processor 2 and the second processor 3. In some embodiments, the number of the processors in the processor module M is not limited to two, and other numbers of processors may be included, which is not limited in the present invention.

In some embodiments, the controller may be applied to a driverless vehicle. The processor module M may be configured for environment perception, intelligent networking, positioning, path planning, and vehicle control. For example, the processor module M may acquire an image from the camera, and recognize the object or the obstacle that may be encountered on the road such as a person, a bicycle, a vehicle, a traffic light, a road sign, or the like in the image by deep learning. In some embodiments, the first processor 2 and the second processor 3 may be a field programmable gate array (FPGA).

In some embodiments, the security micro control unit 1 includes a serial peripheral interface (SPI) and a plurality of general-purpose input/output (GPIO) interfaces, and the first processor 2 includes a init_done interface, an error_flag interface, a status out interface, a reset interface, a GPIO interface, and a SPI. The init_done interface, the error_flag interface, the status out interface, the reset interface, and the GPIO interface of the first processor 2 are coupled to the plurality of the GPIO interfaces of the security micro control unit 1 respectively, and the SPI of the security micro control unit 1 is coupled to the SPI of the first processor 2 correspondingly. In the embodiment of the present invention, based on the interfaces, the first processor 2 may report its running state to the security micro control unit 1 in real time, and the secure micro control unit 1 may monitor the running state of the first processor 2 in real time based on hardware and/or software. For example, the security micro control unit 1 may monitor the condition, such as the initialization, the power up process, and the timing status of the first processor 2 based on the init_done interface, the error_flag interface, and the status out interface.

The security micro control unit 1 may, through the GPIO interface, synchronize the clock and task timing with the first processor 2, and monitor the running timing of the internal software of the first processor 2. Moreover, the security micro control unit 1 may, through the SPI, monitor the condition of the first processor 2, such as the status of the internal configuration register, the status of the kernel power, the security status of the internal software, the status of memory management, the status of time management, the status of timing management, and the status of data from the camera module. When the security micro control unit 1 monitors that the running state of the first processor 2 is abnormal, the security micro control unit 1 may force the first processor 2 to perform operations such as reset, interruption, power failure, or mode switching, such that the first processor 2 can resume a normal state, thereby improving the safety and reliability of the controller. When the security micro control unit 1 cannot cause the first processor 2 to resume the normal state, the security micro control unit 1 may send the fault of the first processor 2 to a standby controller, an acousto-optic alarm, or the like in the driverless vehicle, to trigger the standby controller, the acousto-optic alarm, the electrical power system (EPS), the security backup system to perform the corresponding processing/emergency mechanisms.

Similarly, the connection between the security micro control unit 1 and the second processor 3 may be referred to the connection between the security micro control unit 1 and the first processor 2, and details are not described herein again. In the embodiment of the present invention , the second processor 3 may report its running state to the security micro control unit 1 in real time, and the secure micro control unit 1 may monitor the running state of the second processor 3 in real time based on hardware and/or software. For example, the security micro control unit 1 may monitor the condition, such as the initialization, the power up process, and the timing status of the second processor 3 based on the init_done interface, the error_flag interface, and the status out interface.

The security micro control unit 1 may, through the GPIO interface, synchronize the clock and task timing with the second processor 3, and monitor the running timing of the internal software of the second processor 3. Moreover, the security micro control unit 1 may, through the SPI, monitor the condition of the second processor 3, such as the status of the internal configuration register, the status of the kernel power, the security status of the internal software, the status of memory management, the status of time management, the status of timing management, and the status of data from the camera module. When the security micro control unit 1 monitors the running state of the second processor 3 is abnormal, the security micro control unit 1 may force the second processor 3 to perform operations such as reset, interruption, power failure, or mode switching, such that the second processor 3 can resume a normal state, thereby improving the safety and reliability of the controller. When the security micro control unit 1 cannot cause the second processor 3 to resume the normal state, the security micro control unit 1 may send the fault of the second processor 3 to a standby controller, an acousto-optic alarm, or the like in the driverless vehicle, to trigger the standby controller, the acousto-optic alarm, the EPS, the security backup system to perform corresponding processing/emergency mechanisms.

In the embodiment of the present invention, the security micro control unit 1 may operate independently of the main CPU (such as the first processor 2 and the second processor 3) of the controller, and be configured to monitor the running state of the first processor 2 and the second processor 3, such that the fault of the first processor 2 or the second processor 3 can be detected and handled timely, the fault scene can be protected, thereby improving the safety and reliability of the controller. In an embodiment, the security micro control unit 1 may adopt a micro control unit (MCU) that meets at least functional safety requirements of the automotive safety integrity level standard (ASIL-D) defined by the international functional safety standard ISO 26262, which further enhances the safety and reliability of the controller.

The controller ACU further includes a power management module 4. The power management module 4 is coupled to the security micro control unit 1, and configured to monitor the running state of the security micro control unit 1. The security micro control unit 1 is configured to monitor the running state of the power management module 4.

In some embodiments, the power management module 4 may be a power management integrated circuit (PMIC) satisfying the functional safety requirements of ASIL-D. The power management module 4 includes a ROT interface, the security micro control unit 1 includes a POR interface. The POR interface of the security micro control unit 1 is coupled to the ROT interface of the power management module 4. The security micro control unit 1 and the power management module 4 may monitor each other mutually, the security micro control unit 1 and the power management module 4 may mutually report their running state to each other in real time, and monitor the security of each other based on hardware and/or software.

For example, the security micro control unit 1 may monitor the running state (such as whether the static mode is awakened, whether the accuracy of the output power is insufficient, or whether over temperature or overload occurs) of the internal state machine of the power management module 4 through the interruption monitoring interface INT and the error monitoring interface ERR of the power management module 4. The security micro control unit 1 may also periodically monitor the register data monitored internally by the power management module 4 through the SPI, to learn whether the power management module 4 has a fault such as output voltage overvoltage, power jitter, or ringing.

For example, the power management module 4 may monitor the security micro control unit 1 through the SPI. During normal operation, the security micro control unit 1 may periodically report its current running state to the power management module 4 through the SPI, the running state of the security micro control unit 1 may include the internal error, such as task dispatching timeout or thread process delay. The power management module 4 may also monitor the security micro control unit 1 through a watchdog (WD) interface. During normal operation, the security micro control unit 1 may periodically send a watchdog input signal to the WD interface, when the security micro control unit 1 runs out of control, runs out of truck, or fails to send the watchdog input signal to the PMIC within the required time window, the power management module 4 may consider that the security micro control unit 1 has a fault.

When the security micro control unit 1 monitors that the running state of the power management module 4 is abnormal, the security micro control unit 1 may force the power management module 4 to return to the normal state by resetting or the like. When the power management module 4 monitors the running state of the security micro control unit 1 is abnormal, the power management module 4 may force the security micro control unit 1 to return to the normal state by resetting or the like. Therefore, the safety level of the controller can be improved. When the security micro control unit 1 cannot make the power management module 4 return to the normal state, the security micro control unit 1 may report the fault of the power management module 4 to the standby controller, the acousto-optic alarm, or the like in the driverless vehicle, to trigger the standby controller or the acousto-optic alarm to perform corresponding processing/emergency mechanisms. Similarly, when the power management module 4 cannot make the security micro control unit 1 return to the normal state, the power management module 4 may report the fault, to trigger the corresponding processing/emergency mechanisms.

In the embodiment of the present invention, the power management module 4 and the security micro control unit 1 may form a safety island hardware monitoring system, which satisfies the ASIL-D, and operate independently of the main CPU of the controller, thereby improving the safety and reliability of the controller.

In the embodiment of the present invention, the controller further includes a power supply 5 and a processor power supply subsystem 6. The processor power supply subsystem 6 is coupled to the power supply 5 and the processor module M, and configured to provide an operating voltage to the processor module M based on a power supply voltage output by the power supply.

The output end of the power supply 5 is coupled to the processor power supply subsystem 6, and configured to provide a power supply voltage (e.g., 12V) to the processor power supply subsystem 6. The processor power supply subsystem 6 includes a plurality of voltage output interfaces, and each of the plurality of voltage output interfaces is coupled to the processor module M through a corresponding resistor, to output the operating voltage to the processor module M. For example, the plurality of voltage output interfaces may output operating voltages, such as 0.85V, 0.9V, 1.0V, 1.2V, 1.8V, and 3.3V, respectively. FIG. 2 illustrates the case where three voltage output interfaces are coupled to the processor module M through resistors R7, R8 and R9, and the three voltage output interfaces output the operating voltage of 0.85V, 1.2V, and 1.2V. Specifically, the processor power supply subsystem 6 may be configured to provide the first processor 2 and the second processor 3 with their respective required operating voltage based on the power supply voltage output by the power supply 5.

In the embodiment of the present invention, the power supply voltage output by the power supply 5 may be 12V, and the operating voltage of each of the first processor 2 and the second processor 3 may be determined according to actual conditions. For example, the operating voltage of the first processor 2 and the second processor 3 may be 1.2V.

In some embodiments, the processor power supply subsystem 6 may be provided with a state machine. The processor power supply subsystem 6 may include two WDI interfaces, the two WDI interfaces are coupled to the GPIO interface of the first processor 2 and the GPIO interface of the second processor 3, respectively, to monitor on the first processor 2 and the second processor 3. When it is monitored that the first processor 2 or the second processor 3 runs out of control, or the first processor 2 or the second processor 3 fails to provide the watchdog input signal to the processor power supply subsystem 6 within the required time, the processor power supply subsystem 6 restore the first processor 2 or the second processor 3 to the normal operation by re-powering on the processor.

In some embodiments, the security micro control unit 1 is coupled to the processor power supply subsystem 6, and configured to monitor the running state of the processor power supply subsystem 6. Specifically, the processor power supply subsystem 6 may further include an INT interface, a FSOB interface, a PGOOD interface, a PWRON interface, an EWARN interface, and an I2C interface. The plurality of GPIO interfaces of the security micro control unit 1 are coupled to the INT interface, the FSOB interface, the PGOOD interface, the PWRON interface, the EWARN interface, and the I2C interface of the processor power supply subsystem 6, respectively. In addition, the secure micro control unit 1 may further include multiple pairs of differential ADC sampling interfaces DIFF_ADC_P and DIFF_ADC_N, and each pair of the differential ADC sampling interfaces DIFF_ADC_P and DIFF_ADC_N are respectively coupled to both ends of the resistor corresponding to the voltage output interface of the processor power supply subsystem 6.

Based on the above interfaces, the processor power supply subsystem 6 may report its current running state to the security micro control unit 1 in real time, and the security micro control unit 1 can monitor the running state of the processor power supply subsystem 6 in real time based on hardware and/or software. For example, the security micro control unit 1 may monitor the power up sequence of the processor power supply subsystem 6 by the PGOOD interface. The security micro control unit 1 may monitor, through the INT interface, the PWRON interface, and the EWARN interface, the faults of different configurations inside the processor power supply subsystem 6, such as power supply accuracy error, inaccurate power-on time, and the like. The security micro control unit 1 may monitor, through the I2C interface and the FSOB interface, the condition of the voltage output of the processor power supply subsystem 6 by, such as spikes, overvoltage, or undervoltage. The security micro control unit 1 may acquire the differential voltage across the corresponding resistor through the differential ADC sampling interface, and calculate the corresponding current value. When the current value has problems such as overcurrent, transient current surge or insufficient supply of transient current, the processor module 4 may be damaged instantly, or the processor module 4 may stop operating instantly, or the processor module 4 may instantly have an error in the calculation value, which will affect the driving safety of the driverless vehicle. Thus, by monitoring the current value, the security micro control unit 1 can monitor problems such as overcurrent, transient current surge or insufficient transient current supply, thereby improving the safety and reliability of the controller.

In the embodiment of the present invention, the security micro control unit 1 may configure the output sequence of each voltage output of the processor power supply subsystem 6 through the I2C interface, and control on/off of the power source of the processor power supply subsystem 6 through the I2C interface. When the security micro control unit 1 monitors that the running state of the processor power supply subsystem 6 is abnormal, the security micro control unit 1 may force the processor power supply subsystem 6 to return to the normal state by resetting or the like. When the processor power supply subsystem 6 cannot return to the normal state, the security micro control unit 1 may report the fault of the processor power supply subsystem 6 to the standby controller, the acousto-optic alarm, or the like in the driverless vehicle, to trigger the standby control, the acousto-optic alarm, the EPS, and the security backup system to deploy corresponding processing/emergency mechanisms.

In some embodiments, the controller may further include an emergency power supply subsystem 7. The emergency power supply subsystem 7 is coupled to the power supply 5 and the power management module 4, and the power supply 5 is coupled to the power management module 4. Specifically, the power management module 4 includes a VST interface, and the output end of the power supply 5 is coupled to the VST interface of the power management module 4 to output a power supply voltage (such as 12V) to the power management module 4. The emergency power supply subsystem 7 is coupled to the VST interface of the power management module 4.

The emergency power supply subsystem 7 is configured to provide an operating voltage to the power management module 4 based on the pre-stored power quantity when the power supply 5 fails (such as interruption fault), such that the power management module 4 can maintain the normal operating state. The pre-stored power quantity is power stored by the emergency power supply subsystem 7 based on the power supply voltage (such as 12V) output by the power supply 5 before the power supply 5 fails. In the embodiment of the present invention, the pre-stored power quantity may enable the power management module 4 to maintain independent operating (normal operating) for at least 500 milliseconds, such that the power management module 4 can protect the fault scene where the monitored object occurs.

In the embodiment of the present invention, the power management module 4 may be configured to provide the operating voltage to the security micro control unit 1 based on the power supply voltage output by the power supply 5 when the power supply 5 does not fail, and provide the operating voltage to the security micro control unit 1 based on the power supply voltage output by the emergency power supply subsystem 7 when the power supply 5 fails. For example, the operating voltage of the security micro control unit 1 is 3.3V, 5V, when the power supply 5 fails (such as interruption fault), the security micro control unit 1 may maintain normal operation based on the operating voltage output by the power management module 4, thereby protecting the fault scene where the monitored object occurs.

When the power supply 5 fails (such as interruption fault), the running state of the first processor 2 and the second processor 3 may be affected, in this case, the security micro control unit 1 may monitor the running state of each of the first processor 2 and the second processor 3 according to the operating voltage output by the power management module 4, and start the standby controller when it is monitored that the running state of the first processor 2 or the second processor 3 is abnormal. The standby controller may at least have the functions of the first processor and the second processor, and can be configured to control the operation of the driverless vehicle. When it is monitored that the running state of the first processor 2 or the second processor 3 is abnormal, the standby controller may be started to control the operation of the driverless vehicle.

In some embodiments, the emergency power supply subsystem includes a charge management power chip and a capacitor. When the capacitor is fully charged based on the power supply voltage output by the power supply 5, the capacitor is no longer charged or discharged. When the power supply 5 is interrupted, the capacitor may be discharged, to cause the power management module 4 to operate at least 500 milliseconds normally.

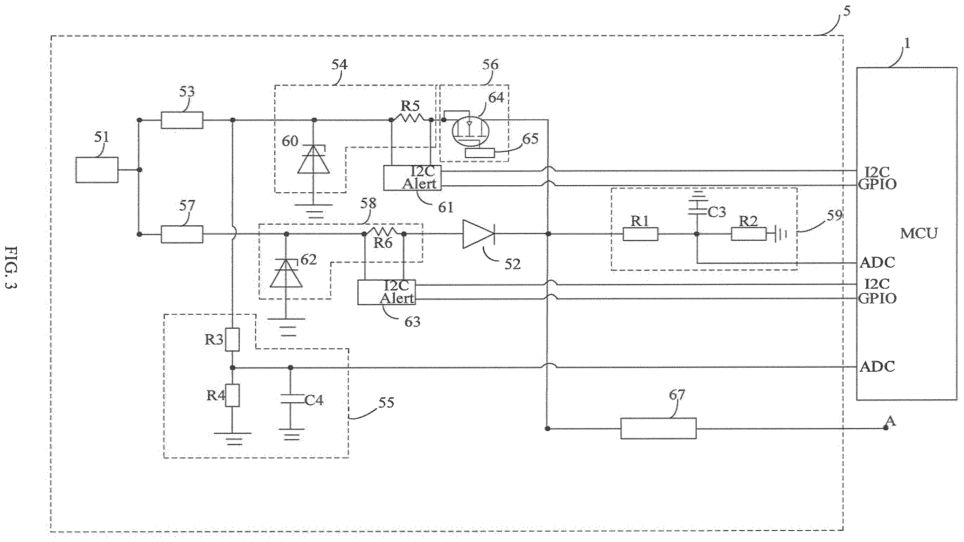

FIG. 3 is a schematic diagram of a power supply 5 according to FIG. 2. In some embodiments, as illustrated in FIG. 3, the power supply 5 includes a power source 51, a main power supply circuit, and a standby power supply circuit. An input end of the main power supply circuit and an input end of the standby power supply circuit are coupled to the power source 51, respectively, and an output end of the main power supply circuit is coupled to the joint node 0. An output end of the standby power supply circuit is coupled to the joint node 0 through a switching component 52, and the joint node 0 is coupled to the processor power supply subsystem 6 and the emergency power supply subsystem 7.

The power source 51 is configured to provide a power supply voltage to the main power supply circuit and the standby power supply circuit, for example, the power supply voltage may be 12V The switching component 52 is configured to switch on the connection between the standby power supply circuit and the joint node 0 when the main power supply circuit fails (such as interruption fault). In the embodiment of the present invention , in the normal operating state, the power source 51 outputs the power supply voltage through the main power supply circuit, when a fault such as interruption occurs in the main power supply circuit, the connection between the standby power supply circuit and the joint node 0 may be conducted by the switching component 52, to switch to the mode of supplying power by the standby power supply circuit. In this case, the power source 51 may output the supply voltage through the standby power supply circuit. In the process of switching to the standby power supply circuit to supply power, there is no voltage drop, which satisfies the design of heterogeneous redundancy.

In the embodiment of the present invention, as illustrated in FIG. 3, the switching component 52 includes a first diode, the output end of the standby power supply circuit is coupled to an anode of the first diode, and the cathode of the first diode is coupled to the joint node 0. In the normal operating state, the power source 51 may output the power supply voltage to the main power supply circuit and the standby power supply circuit, the voltage of both ends of the first diode 52 is the same, such that the standby power supply circuit will not be powered on, and the standby power supply circuit will be in a current power consumption free state, the power supply voltage output by the power source 51 is transmitted to the joint node 0 only through the main power supply circuit. When the main power supply circuit fails (such as interruption fault), the voltage at the joint node 0 (i.e., the cathode of the diode) may change, resulting a voltage difference on both ends of the first diode, which may cause the first diode to be conducted, and the connection between the standby power supply circuit and the joint node 0 can be powered on. In this case, the power source 51 may output the power supply voltage to the joint node 0 through the standby power supply circuit.

In some embodiments, as illustrated in FIG. 3, the main power supply circuit includes a first connector 53, a first electrostatic protection circuit 54, a first interruption detection circuit 55, and an anti-reverse protection circuit 56. An input end of the first connector 53 is coupled to the power source 51, and the first electrostatic protection circuit 54 and the first interruption detection circuit 55 are coupled to an output end of the first connector 53, respectively. The anti-reverse protection circuit 56 is coupled to the first electrostatic protection circuit 54, and the anti-reverse protection circuit 56 is further coupled to the joint node 0.

As illustrated in FIG. 3, the standby power supply circuit includes a second connector 57, a second electrostatic protection circuit 58, and a second interruption detection circuit 59. The switching component 52 may be considered as an anti-reverse protection circuit for the standby power supply circuit. An input end of the second connector 57 is coupled to the power source 51, the second electrostatic protection circuit 58 is coupled to an output end of the second connector 57. The anode of the switching component 52 (the first diode) is coupled to the second electrostatic protection circuit 58, and the second interruption detection circuit 59 is coupled to the cathode of the switching component 52 (the first diode).

In some embodiments, the input end of the first connector 53 of the main power supply circuit and the input end of the second connector 57 of the standby power supply circuit may achieve 12V power output by connecting the power supply cable on the driverless vehicle.

In some embodiments, as illustrated in FIG. 3, the security micro control unit 1 is coupled to the first interruption detection circuit 55 for monitoring the running state of the first interruption detection circuit 55. Specifically, the first interruption detection circuit 55 includes a third resistor R3, a fourth resistor R4, and a fourth capacitor C4. An end of the third resistor R3 is coupled to the output end of the first connector 53, and the other end of the third resistor R3 is coupled to an end of the fourth resistor R4, an end of the fourth capacitor C4, and the ADC interface of the security micro control unit 1, respectively. The other end of the fourth resistor R4 and the other end of the fourth capacitor C4 are grounded, respectively. For example, the security micro control unit 1 may perform differential input ADC detection on the first interrupt detection circuit 55 to monitor the status (such as interruption fault) of the main power supply circuit.

In some embodiments, as illustrated in FIG. 3, the security micro control unit 1 is coupled to the second interruption detection circuit 59 for monitoring the running state of the second interruption detection circuit 59. Specifically, the second interruption detection circuit 59 includes a first resistor R1, a second resistor R2, and a third capacitor C3. An end of the first resistor R1 is coupled to the cathode of the first diode 52, and the other end of the first resistor R1 is coupled to an end of the second resistor R2, an end of the third capacitor C3, and the ADC interface of the security micro control unit 1. The other end of the second resistor R2 and the other end of the third capacitor C3 are grounded, respectively. For example, the security micro control unit 1 may perform differential input ADC detection on the second interruption detection circuit 59 to monitor the status (such as interruption fault) of the standby power supply circuit.

In some embodiments, as illustrated in FIG. 3, the first electrostatic protection circuit 54 includes a second diode 60 and a fifth resistor R5. A first end of the second diode 60 is grounded, and a second end of the second diode 60 is coupled to the output end of the first connector 53, an end of the fifth resistor R5 is coupled to the output end of the first connector 53, and the other end of the fifth resistor R5 is coupled to the anti-reverse protection circuit 56.

In some embodiments, as illustrated in FIG. 3, both ends of the fifth resistor R5 are coupled to a first current monitor 61. The first current monitor 61 is configured to monitor the current power flowing through the fifth resistor R5. In some embodiments, the model of the first current monitor 61 may be INA226 AQDGSRQ1. As illustrated in FIG. 3, the security micro control unit 1 is coupled to the first current monitor 61 for monitoring the running state of the first current monitor 61, for example, by monitoring the condition of the current value of the fifth resistor R5 through the first current monitor 61. Specifically, as illustrated in FIG. 3, the I2C interface of the security micro control unit 1 is coupled to the I2C interface of the first current monitor 61, and the GPIO interface of the security micro control unit 1 is coupled to an alert interface of the first current monitor 61.

In some embodiments, as illustrated in FIG. 3, the anti-reverse protection circuit 56 includes a PMOS (positive channel metal oxide semiconductor) transistor 64 and a diode controller 65. A first pole of the PMOS transistor 64 is coupled to the other end of the fifth resistor R5, a second pole of the PMOS transistor 64 is coupled to the joint node 0, and the controller of the PMOS transistor 64 is coupled to the diode controller 65. The diode controller 65 is configured to control the on/off of the PMOS transistor 64. In some embodiments, the model of the diode controller 65 may be LM7461OQDGKRQ1.

In some embodiments, as illustrated in FIG. 3, the second electrostatic protection circuit 58 includes a third diode 62 and a sixth resistor R6. A first end of the third diode 62 is grounded, and the second end of the third diode 62 is coupled to the output end of the second connector 57, an end of the sixth resistor R6 is coupled to the output end of the second connector 57, and the other end of the sixth resistor R5 is coupled to the anode of the switching component 52.

In some embodiments, as illustrated in FIG. 3, both ends of the sixth resistor R6 are coupled to a second current monitor 63, and the second current monitor 63 is configured to monitor the current power flowing through the sixth resistor R6. In some embodiments, the model of the second current monitor 63 may be INA226 AQDGSRQ1. As illustrated in FIG. 3, the security micro control unit 1 is also coupled to the second current monitor 63 for monitoring the running state of the second current monitor 63, for example, by monitoring the current value of the sixth resistor R6 through the second current monitor 63. Specifically, as illustrated in FIG. 3, the I2C interface of the security micro control unit 1 is coupled to the I2C interface of the second current monitor 63, and the GPIO interface of the security micro control unit 1 is coupled to the alert interface of the second current monitor 63.

In some embodiments, the power source 5 further includes a voltage filtering circuit 67. An input end of the voltage filtering circuit 67 is coupled to the joint node 0, and the output end of the voltage filtering circuit 67 is coupled to the processor power supply subsystem 6, the emergency power supply subsystem 7, and the power management module 4. In other words, the joint node 0 is coupled to the processor power supply subsystem 6, the emergency power supply subsystem 7, and the power management module 4 through the voltage filtering circuit 67.

When the power supply voltage output by the main power supply circuit or the standby power supply circuit reaches the joint node 0, the power supply voltage is transmitted to the node A via the voltage filtering circuit 67, and the node A is coupled to the processor power supply subsystem 6, the emergency power supply subsystem 7, and the power management module 4. The voltage filtering circuit 67 is configured to filter the voltage flowing through it.

In some embodiments, the security micro control unit 1 can monitor the running state of the power supply 5 in multiple directions, which satisfies the functional safety requirements of ASIL-D. When the running state of any one of the main power supply circuit and the standby power supply circuit is abnormal, the fault may be reported to the security backup system through the CAN (controller area network) communication bus to start the corresponding backup mechanism, and the vehicle owner can be prompted to repair the vehicle timely. Even when the entire system of the controller fails, the state of the power supply 5 of the controller can still be determined through the security backup system, which satisfies the requirements for decision-making monitoring outside the system.

In the actual environment, during the traveling process of the vehicle, due to vibration, rain and snow, etc., the vehicle interior may have high humidity, and deformation of the material may be caused due to high salinity corrosion, high and low temperature in the coastal city. In such environment, the external connector of the 12V power supply (KL.30 electric) cable and the power supply of the controller in the vehicle may be liable to cause failures such as looseness, corrosion, increased insulation resistance, and impedance control drift. In the embodiment, the power supply 5 adopts the design of dual redundant power supply circuit, and the security micro control unit 1 can monitor and diagnose its fault, such that the impact of the above faults on the controller can be basically eliminated from the perspective of functional safety and reliability of automotive electronics products.

In some embodiments, as illustrated in FIG. 2, the power management module 4 is provided with a security channel signal source, and the security channel signal source is coupled to the security micro control unit 1 and an external standby controller 8. The power management module 4 is further configured to, when a security fault occurs in the security micro control unit, trigger the security channel signal source to send a security channel signal to the external standby controller 8 to start the standby controller. When the security fault occurs in the security micro control unit, the standby controller may control the operation of the vehicle by controlling a lateral actuator and/or a longitudinal actuator (such as an electronic steering wheel assisting system, an engine management system), such that the vehicle can run slowly or even stop.

The security micro control unit 1 is configured to trigger the security channel signal source to send a security channel signal to the external standby controller 8 to start the standby controller 8 when monitoring that the security fault occurs in the first processor or the second processor. When the security fault occurs in the first processor or the second processor, the standby controller 8 may control the operation of the vehicle by controlling a lateral actuator and/or a longitudinal actuator (such as an electronic steering wheel assisting system, an engine management system), such that the vehicle can run slowly or even stop.

Specifically, the security channel signal sources include two security channel signal sources SS1 and SS2, the security channel signal source SS1 is configured to issue a security channel signal A, and the security channel signal source SS2 is configured to issue a security channel signal B. When the power management module 4 monitors that a security fault occurs in the security micro control unit 1, the security channel signal source SS1 may be triggered to send a security channel signal A to the external standby controller 8, to inform the standby controller 8 of the security fault of the security micro control unit 1. After a period of time, when the security micro control unit 1 still cannot remove the fault by itself, or the power management module 4 cannot remove the fault by resetting or other means, the power management module 4 may trigger the security channel signal source SS2 to issue a security channel signal B to the external standby controller 8, to start the standby controller to control the driverless vehicle. The security channel signal A may be a low-level signal, such as 0V, and the security channel signal B may be a high-level signal, such as 3.3V. In some embodiments, a drive level shifter circuit N may be disposed between the security channel signal source SS2 and the standby controller 8, for translating 3.3V high-level signal into 12V high-level signal to start the standby controller.

Similarly, when the security micro control unit 1 monitors the security fault occurs in the first processor 2 or the second processor 3, the security channel signal source SS1 may be triggered to send a security channel signal A to the external standby controller 8, to inform the standby controller 8 of the security fault of the first processor 2 or the second processor 3. After a period of time, when the first processor 2 or the second processor 3 cannot remove the fault by itself or the security micro control unit 1 cannot remove the fault by resetting or other means, the security micro control unit 1 may trigger the security channel signal source SS2 to issue a security channel signal B to the external standby controller 8, to start the standby controller to control the driverless vehicle.

In some embodiments, the security micro control unit 1 is coupled to an external acousto-optic alarm 18, when the power management module 4 monitors that the security fault occurs in the security micro control unit 1, or when the security micro control unit 1 monitors that the security fault occurs in the second processor 2 or the second processor 3, the security channel signal may be configured to trigger the external acousto-optic alarm to issue the acousto-optic alarm. The security micro control unit 1 is coupled to the external acousto-optic alarm 18 through a GPIO interface. In some embodiments, the external acousto-optic alarm 18 may be an instrument acousto-optic alarm.

In the embodiment, the security micro control unit 1 includes a plurality of external interfaces, and the plurality of external interfaces are configured to connect the camera module 9, the motion measurement module 10, the Ethernet communication module 11, the CAN communication module 12, the heat dissipation module 13, the vehicle speed signal acquisition circuit 14, the steering wheel angle signal acquisition circuit 15, the brake signal acquisition circuit 16, and the gear signal acquisition circuit 17, respectively. The camera module 9 may be a sensor configured to sense the object and environment around the driverless vehicle, and provide raw image data to the processor module M as a data source for depth learning algorithm of the processor module M. The motion measurement module 10 is configured to provide data of the vehicle posture (such as roll, pitch, and yaw, etc.) to inform the current status such as turning and uphill of the vehicle. The Ethernet communication module 11 is configured to provide a data communication interface between the controller and other controllers (such as a TBOX controller) on the vehicle. The CAN communication module 12 is configured to provide an interface for vehicle control data interaction between the controller and other controllers (such as vehicle control unit (VCU), EPS, electronic stability program (ESP) and other controllers) on the vehicle, to provide a control medium for the controller to control the vehicle. The heat dissipation module 13 is configured to provide a heat dissipation function to the controller.

In the embodiment of the present invention, the security micro control unit 1 is configured to monitor the running state of each of the camera module 9, the motion measurement module 10, the Ethernet communication module 11, the CAN communication module 12, the heat dissipation module 13, and the vehicle speed signal acquisition circuit 14, the steering wheel angle signal acquisition circuit 15, the brake signal acquisition circuit 16, and the gear signal acquisition circuit 17. The security micro control unit 1 may control the operation of the heat dissipation module 13, and control the on/off of the camera module 9. When it is monitored that a module or the acquisition circuit fails (such as interruption fault), the security micro control unit 1 may force the module or the acquisition circuit to return to normal operation by resetting or other means, when the fault cannot be removed, the security micro control unit 1 may report the fault to the standby controller, or the acousto-optic alarm, to trigger the corresponding emergency mechanism.

In some embodiments, the camera module 9 includes a camera 91, a high-side analog switch chip 92, and a dedeserializer 93. The security micro control unit 1 is coupled to the camera 91 through the high-side analog switch chip 92, the first processor 2 is coupled to the camera 91 through the deserializer 93, and the second processor 3 is coupled to the camera 91 through the deserializer 93. In some embodiments, the camera 91 may include the FPD-LINK-II FAKARA chip, the model of the high-side analog switch chip 92 may be TLE75080-ESD, and the model of the deserializer 93 may be FPD-LINK-2. In an embodiment, the SPI of the security micro control unit 1 is coupled to the SPI of the high-side analog switch chip 92, and the GPIO interface of the security micro control unit 1 is coupled to the INT interface of the high-side analog switch chip 92, and another GPIO interface of the security micro control unit 1 is coupled to an IDLE interface of the high-side analog switch chip 92. The security micro control unit 1 is configured to monitor the running state of the camera module 9. For example, the security micro control unit 1 may monitor the electrical state of the FAKARA interface of the camera through the high-side analog switch chip 92, and the security micro control unit 1 is coupled to the SPI bus of the high side analog switch chip 92, and can monitor the status of the port, such as open circuit, overcurrent, ground drift, and impedance instability. Moreover, the security micro control unit 1 may set the mode of the FAKARA interface of the camera to an idle operating mode through the IDLE interface.

In some embodiments, a port of the CAN communication module 12 is provided with a dedicated CAN bus interface chip, the chip includes a RX interface, a TX interface, a STB interface, and an ERR interface. The CAN_RX interface of the security micro control unit 1 is coupled to the RX interface of the chip, the CAN_TX interface of the security micro control unit 1 is coupled to the TX interface of the chip, a GPIO interface of the security micro control unit 1 is coupled to the STB interface of the chip, and another GPIO interface of the security micro control unit 1 is coupled to the ERR interface of the chip. The ERR interface of the chip can inform the security micro control unit 1 of the fault of CAN bus, such as dominant-clamping, time out, overvoltage, undervoltage, overtemperature, and abnormal cold start. In some embodiments, the model of the CAN bus interface chip may be TJA1043.

In some embodiments, the heat dissipation module 13 includes a fan drive chip and a fan. The IN interface of the fan drive chip is coupled to a GPIO interface of the security micro control unit 1. The SPI of the fan drive chip is coupled to the SPI of the security micro control unit 1. The security micro control unit 1 may communicate with the fan drive chip through the SPI, to monitor the running state of the fan, such as jitter, overcurrent, open circuit, ground drift, short circuit, overcurrent and overvoltage.

In some embodiments, the motion measurement module 10 may be an inertial measurement unit (IMU) that meets the security level of at least ASIL-B. The SPI of the motion measurement module 10 is coupled to the SPI interface of the security micro control unit 1, the Alerm interface of the motion measurement module 10 is coupled to the INT_GPIO interface of the security micro control unit 1, and the reset interface of the motion measurement module 10 is coupled to the GPIO interface of the security micro control unit 1. The security micro control unit 1 may monitor the faults, such as overcurrent, overtemperature, damage to gyroscope, physical damage to the three axes, of the motion measurement module 10 through the SPI interface. In order to rapidly send the fault, the motion measurement module 10 may inform the security micro control unit 1 of its fault at the fastest speed through the Alerm interface.

In some embodiments, the security micro control unit 1 is coupled to the Ethernet communication module 11 through the SPI bus, to learn the status (such as delay, packet loss, or other faults) of the Ethernet communication module 11 through the SPI bus. In some embodiments, the security micro control unit 1 may acquire the vehicle speed signal, the steering wheel angle signal, the brake signal and the gear signal through the CAN bus.

In some embodiments, the vehicle speed signal acquisition circuit 14 is coupled to the PWM_PULSE IN interface of the security micro control unit 1, and configured to transmit the vehicle speed signal acquired to the security micro control unit 1. The steering wheel angle signal acquisition circuit 15 is coupled to the PWM_PULSE IN interface of the security micro control unit 1, and configured to transmit the steering wheel angle signal acquired to the security micro control unit 1. The brake signal acquisition circuit 16 is coupled to a GPIO interface of the security micro control unit 1, and configured to transmit the brake signal acquired to the security micro control unit 1. The gear signal acquisition circuit 17 is coupled to a GPIO interface of the security micro control unit 1, and configured to transmit the gear signal acquired to the security micro control unit 1. The security micro control unit 1 may monitor the signal output by each of the vehicle speed signal acquisition circuit 14, the steering wheel angle signal acquisition circuit 15, the brake signal acquisition circuit 16 and the gear signal acquisition circuit 17 through the GPIO interface or PWM interface. When the signal output by any of the acquisition circuit is interrupted for a long time, there will be no signal input at the PWM interface or the GPIO interface of the security micro control unit 1, the security micro control unit 1 may learn that the running state of the acquisition circuit is abnormal.

In the embodiment of the present invention, the security micro control unit 1 may divide the security mode of the controller into six levels based on the running state monitored of respective object. The six levels may include a normal operation mode, a performance loss mode, a general error mode, a serious error mode, a security error mode, and a security fault mode. For each mode, a corresponding processing mechanism or emergency mechanism can be set. For example, when the security micro control unit 1 monitors that the first processor 2 or the second processor 3 has a security fault, the standby controller can be started to control the vehicle. The security fault may be understood as the abnormal fault that may threaten the driving safety and cannot be restored to normal operation by resetting or other means.

In an embodiment, when the following cases occur, it may be considered that the controller is in the normal operation mode. For example, all functional modules of the controller operate normally, the circuit board runs at full power consumption, frequencies of all working clock are the highest, the task management, threads and processes run normally, memory monitoring is normal, and there is no abnormality in the monitored circuits of the security micro control unit 1.

In an embodiment, when the following cases occur, it may be considered that the controller is in the performance loss mode, the power management module 4 does not need to do any processing in this case. For example, the processor power supply subsystem 6, the first processor 2, or the second processor 3 generates a certain amount of heat, the function is not affected, and the security micro control unit 1 can turn on the heat dissipation module 13 to dissipate heat. The data captured by the camera shows a decline in image quality, the function realization of the controller is not affected, the overall performance indicator (such as reaction speed) of the controller is affected. The motion measurement module 10 cannot accurately determine the posture of the vehicle, for example, the turning angle cannot reach the accuracy of 0.1°, and can meet the accuracy of 0.5°, and the requirement of the controller can be met. There is a low proportion of error frames in the CAN bus communication, and the communication function is affected. The vehicle speed signal acquisition circuit 14, the steering wheel angle signal acquisition circuit 15, the brake signal acquisition circuit 16 and the gear signal acquisition circuit 17 have performance loss, and the security micro control unit 1 can handle it by increasing the sampling frequency of the signals for monitoring the above circuit.

In an embodiment, when the following cases occur, it may be considered that the controller is in the general error mode, the power management module 4 does not need to do any processing in this case. For example, the processor power supply subsystem 6, the first processor 2, or the second processor 3 generates a certain amount of heat, the function implementation may be affected in a low frequency, the security micro control unit 1 may turn on the heat dissipation module 13 to dissipate heat, and increase the sampling frequency for monitoring the first processor 2 or the second processor 3. The image captured by the camera works normally when the image fed back to the first processor 2 or the second processor 3 is 30 frame/second, there is a low probability that the image cannot be used (which may be caused by errors such as jitter, electromagnetic compatibility), the overall function of the controller is not affected, and the faulty image can be discarded. The motion measurement module 10 cannot accurately determine the posture of the vehicle, there may be error data, and the security micro control unit 1 can filter it based on the software algorithm. There is a high proportion of error frames in the CAN bus communication, the communication function is not affected. The vehicle speed signal acquisition circuit, the steering wheel angle signal acquisition circuit, the brake signal acquisition circuit, and the gear signal acquisition circuit are in the general error state, the security micro control unit 1 needs to record the fault, and record and store the occurrence time in the storage space inside the chip.

In an embodiment, when the following cases occur, it may be considered that the controller is in the serious error mode, the power management module 4 does not need to do any processing in this case. For example, the processor power supply subsystem 6, the first processor 2, or the second processor 3 has problems such as logic operation confusion, timing error, timeout of image data flow, or data flow time confusion, the safety of the vehicle is not affected. The image captured by the camera works normally when the image fed back to the first processor 2 or the second processor 3 is 30 frame/second, there is a high probability that the image cannot be used (which may be caused by errors such as jitter, poor contact of camera cable , serious electromagnetic compatibility), the overall function of the controller is affected, and cannot be solved by the software compensation method. The motion measurement module 10 cannot accurately determine the posture of the vehicle, there is error data, the security micro control unit 1 cannot filter it based on the software algorithm, the safety of vehicle is not affected. There is a very high proportion of error frames in the CAN bus communication, the communication function is affected, the security CAN communication channel is not affected, and the safety of the vehicle is not affected. The vehicle speed signal acquisition circuit, the steering wheel angle acquisition circuit, the brake signal acquisition circuit, and the gear signal acquisition circuit are in the serious error state, the security micro control unit 1 needs to record the fault, and store the occurrence time in the storage space inside the chip, and the security micro control unit 1 also needs to check the data sent by the CAN bus and the data sent by the vehicle speed signal acquisition circuit, the steering wheel angle signal acquisition circuit, the brake signal acquisition circuit, and the gear signal acquisition circuit, to determine the circuit having the failure.

In an embodiment, when the following cases occur, it may be considered that the controller is in the security error mode, the power management module 4 does not need to do any processing in this case, the power management module 4 and the security micro control unit 1 can work normally, the security channel signal has not be issued, and the security micro control unit 1 can trigger the vehicle to stop slowly within a set time window, such as 10 seconds. For example, the processor power supply subsystem 6, the first processor 2, or the second processor 3 has problems such as logic operation confusion, timing error, timeout of image data flow, or data flow time confusion, the safety of the vehicle is affected. The image captured by the camera works normally when the image fed back to the first processor 2 or the second processor 3 is 30 frame/second, there is a high probability that the image cannot be used (which may be caused by errors such as jitter, poor contact of camera cable, serious electromagnetic compatibility), most functions of the controller are lost, and cannot be solved by the software compensation method. The determination of parameters such as the distance to the front vehicle, the relative speed, and relative angle is affected, and driving safety of the vehicle is affected. The motion measurement module 10 cannot accurately determine the posture of the vehicle, there is error data, the security micro control unit 1 cannot filter it based on the software algorithm, the safety of the vehicle is affected. There is a higher proportion of error frames in the CAN bus communication, the communication function is affected, the security CAN communication channel is not affected, and the safety of the vehicle is not affected. The vehicle speed signal acquisition circuit, the steering wheel angle acquisition circuit, the brake signal acquisition circuit, and the gear signal acquisition circuit are in the security error state, the security micro control unit 1 needs to record the default, and store the occurrence time in the storage space inside the chip. The serious fault affects the driving safety, CAN bus channel having the failure is discarded, and the data from the CAN bus channel having the failure is rejected.

In an embodiment, when the following cases occur, it may be considered that the controller is in the security fault mode, the state machine in the power management module 4 may trigger the security channel signal source SS1 and SS2 to issue the security channel signals to inform the standby controller of the failure of the controller, the acousto-optic alarm may be triggered by the security channel signal, the controller does not control the vehicle, the standby controller controls the vehicle to enter the safety state, and controls the vehicle to stop. For example, the processor power supply subsystem 6, the first processor 2, or the second processor 3 has problems such as logic operation confusion, timing error, timeout of image data flow, or data flow time confusion, the safety of the vehicle is seriously affected, the first processor 2 or the second processor 3 needs to be turned off. The camera is completely damaged, the determination of parameters such as the distance to the front vehicle, the relative speed, and relative angle is affected, and driving safety of the vehicle is affected. The data of the motion measurement module 10 cannot be used, the driving safety is affected. There are a large number of error frames in the CAN bus communication, the communication function is affected, there are also error frames or communication interruptions in the secure CAN communication channel. The vehicle speed signal acquisition circuit, the steering wheel angle acquisition circuit, the brake signal acquisition circuit, and the gear signal acquisition circuit are in the security fault state, the functions are lost. The power supply from the power management module 4 to the security micro control unit 1 is abnormal, for example, the 3.3V, 5V power supply provided by the power management module 4 to the security micro control unit 1 has faults such as overvoltage, undervoltage, short circuit, or shutdown, the interruption monitoring interface (INT interface) or the error monitoring interface (ERR interface) between the power management module 4 and the security micro control unit 1 are set, the power management module 4 is no longer trusted. The security micro control unit 1 is abnormal, and the watchdog input signal provided by the security micro control unit 1 to the power management module 4 exceeds the window, the power management module 4 considers that the security micro control unit 1 runs out of control. An error occurred in the security micro control unit 1, and the security channel signal is triggered.

With the controller for a driverless vehicle and the driverless vehicle according to embodiments of the present invention , the controller includes a security micro control unit and a processor module, the processor module is coupled to the security micro control unit, and the security micro control unit is configured to monitor the running state of the processor module, the safety and reliability of the controller for the driverless vehicle can be greatly improved.

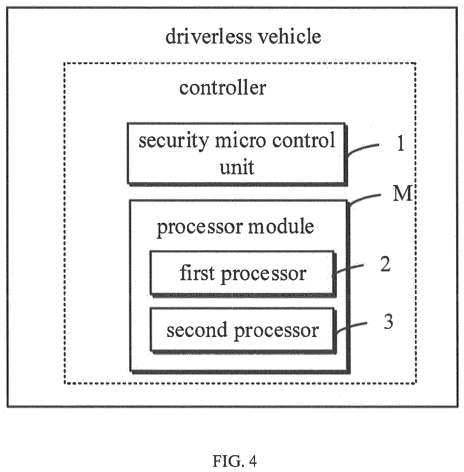

Embodiments of the present invention may further provide a driverless vehicle. FIG. 4 is a schematic diagram a driverless vehicle according to an embodiment of the present invention. As illustrated in FIG. 4, the driverless vehicle includes the controller, the controller may include a security micro control unit 1 and a processor module M. The processor module M includes a first processor 2 and a second processor 3.

As illustrated in FIG. 2, the driverless vehicle includes a standby controller 8, an acousto-optic alarm 18, a camera module 9, a motion measurement module 10, an Ethernet communication module 11, a CAN communication module 12, a heat dissipation module 13, a vehicle speed signal acquisition circuit 14, a steering wheel angle signal acquisition circuit 15, a brake signal acquisition circuit 16, and a gear signal acquisition circuit 17. The camera module 9, the motion measurement module 10, the Ethernet communication module 11, the CAN communication module 12, the heat dissipation module 13, the vehicle speed signal acquisition circuit 14, the steering wheel angle signal acquisition circuit 15, the brake signal acquisition circuit 16, and the gear signal acquisition circuit 17 are coupled to the security micro control unit 1, respectively. The security micro control unit 1 is configured to monitor a running state of each of the camera module 9, the motion measurement module 10, the Ethernet communication module 11, the CAN communication module 12, the heat dissipation module 13, the vehicle speed signal acquisition circuit 14, the steering wheel angle signal acquisition circuit 15, the brake signal acquisition circuit 16, and the gear signal acquisition circuit 17.

In addition, the description of the controller for the driverless vehicle can be referred to the foregoing description of the controller, and details are not described herein again.

Those skilled in the art will appreciate that all or some of the steps, systems, and functional blocks/units of the methods disclosed above may be implemented as software, firmware, hardware, and suitable combinations thereof. In an implementation of hardware, the division between functional modules/units mentioned above does not necessarily correspond to the division of physical components. For example, one physical component may have multiple functions, or one function or step may be implemented by a plurality of physical components together. Certain physical components or all physical components may be implemented as software executed by a processor, such as a central processing unit, a digital signal processor or a microprocessor, or implemented as hardware, or implemented as an integrated circuit, such as an application specific integrated circuit. Such software may be distributed on a computer readable medium, which may include computer storage mediums (or non-transitory media) and communication mediums (or transitory media). Those skilled in the art would understand that, the computer storage medium includes volatile and nonvolatile, removable and non-removable medium implemented in any method or technology for storing information, such as computer readable instructions, data structures, program modules or other data. Computer storage mediums include, but is not limited to, RAM, ROM, EEPROM, flash memory or other memory technology, CD-ROM, digital versatile disc (DVD) or other optical disc storage, magnetic cartridge, magnetic tape, magnetic disk storage or other magnetic storage device, or any other medium used to store the desired information and that can be accessed by the computer. Moreover, it is well known to those skilled in the art that the communication medium typically includes computer readable instructions, data structures, program modules, or other data in a modulated data signal, such as a carrier wave or other transport mechanism, and can include any information delivery medium.

The exemplary embodiments have been disclosed, although specific terms are employed, they are to be interpreted as a general descriptive meaning, and not for limiting purposes. In some instances, those skilled in the art would understand that, the features, characteristics and/or elements described in combination with a specific embodiment may be used alone, or may be used in combination with features, characteristics and/or components that may be described in other embodiments.

## Claims

1. A controller for a driverless vehicle, comprising:
a security micro control unit (1); and
a processor module (M),
wherein the processor module is coupled to the security micro control unit (1), and the security micro control unit (1) is configured to monitor a running state of the processor module (M);
**characterized in that**, the controller further comprises:
a power management module (4), coupled to the security micro control unit (1), and configured to monitor a running state of the security micro control unit (1);
wherein the security micro control unit (1) is configured to monitor a running state of the power management module (4).

2. The controller according to claim 1, wherein the processor module (M) comprises a first processor (2) and a second processor (3), the first processor (2) and the second processor (3) are coupled to the security micro control unit (1), respectively;
the security micro control unit (1) is configured to monitor a running state of each of the first processor (2) and the second processor (3).

3. The controller according to claim 1 or 2, further comprising:
a power supply (5); and
a processor power supply subsystem (6),
wherein the processor power supply subsystem (6) is coupled to the power supply (5) and the processor module (M), and configured to provide an operating voltage to the processor module (M) based on a power supply voltage output by the power supply (5),
the security micro control unit (1) is coupled to the processor power supply subsystem (6), and configured to monitor a running state of the processor power supply subsystem (6).

4. The controller according to claims 2 and 3, further comprising:
an emergency power supply subsystem (7), coupled to the power supply (5) and the power management module (4); wherein,
the power supply (5) is coupled to the power management module (4);
the emergency power supply subsystem (7) is configured to provide an operating voltage to the power management module (4) based on a pre-stored power quantity when the power supply (5) fails;
the power management module (4) is configured to provide an operating voltage to the security micro control unit (1) based on the power supply voltage output by the power supply (5) when the power supply (5) does not fail, and to provide the operating voltage to the security micro control unit (1) based on a power supply voltage output by the emergency power supply subsystem (7) when the power supply (5) fails; and
the security micro control unit (1) is configured to monitor the running state of each of the first processor (2) and the second processor (3) based on the operating voltage provided by the power management module (4), and to start a standby controller when the running state of the first processor (2) or the second processor (3) is abnormal.

5. The controller according to claim 3 or 4, wherein the power supply (5) comprises a power source (51), a main power supply circuit, and a standby power supply circuit,
an input end of the main power supply circuit and an input end of the standby power supply circuit are respectively coupled to the power source (51);
an output end of the main power supply circuit is coupled to a joint node;
an output end of the standby power supply circuit is coupled to the joint node through a switching component (52);
the joint node is coupled to the processor power supply subsystem (6) and the emergency power supply subsystem (7);
the switching component (52) is configured to switch on a connection between the standby power supply circuit and the joint node when the main power supply circuit fails.

6. The controller according to claim 5, wherein the switching component (52) comprises a first diode, the output end of the standby power supply circuit is coupled to an anode of the first diode, and a cathode of the first diode is coupled to the joint node.

7. The controller according to claim 5 or 6, wherein the main power supply circuit comprises a first connector (53), a first electrostatic protection circuit (54), a first interruption detection circuit (55), and an anti-reverse protection circuit (56),
an input end of the first connector (53) is coupled to the power source (51);
the first electrostatic protection circuit (54) and the first interruption detection circuit (55) are coupled to an output end of the first connector (53), respectively;
the anti-reverse protection circuit (56) is coupled to the first electrostatic protection circuit (54), and the anti-reverse protection circuit (56) is further coupled to the joint node; and
the security micro control unit (1) is coupled to the first interruption detection circuit (55), and configured to monitor a running state of the first interruption detection circuit (55).

8. The controller according to claim 5 or 6, wherein the standby power supply circuit comprises a second connector (57), a second electrostatic protection circuit (58), and a second interruption detection circuit (59),
an input end of the second connector (57) is coupled to the power source (51);
the second electrostatic protection circuit (58) is coupled to an output end of the second connector (57);
the anode of the first diode is coupled to the second electrostatic protection circuit (58);
the second interruption detection circuit (59) is coupled to the cathode of the first diode; and
the security micro control unit (1) is coupled to the second interruption detection circuit (59), and configured to monitor a running state of the second interruption detection circuit (59).

9. The controller according to any one of claims 3 to 6, wherein the power supply (5) comprises a voltage filtering circuit (67),
an input end of the voltage filtering circuit (67) is coupled to the joint node; and
an output end of the voltage filtering circuit (67) is coupled to the processor power supply subsystem (6),
the emergency power supply subsystem (7), and the power management module (4).

10. The controller according to any one of claims 3 to 9, wherein the power management module (4) comprises a security channel signal source (SS1, SS2), the security channel signal source (SS1, SS2) is coupled to the security micro control unit (1) and a standby controller (8);
the power management module (4) is configured to trigger the security channel signal source (SS1, SS2) to send a security channel signal to the standby controller (8) to start the standby controller (8) when monitoring that a security fault occurs in the security micro control unit (1);
the security micro control unit (1) is configured to trigger the security channel signal source (SS1, SS2) to send a security channel signal to the standby controller (8) to start the standby controller (8) when monitoring that the security fault occurs in the first processor (2) or the second processor (3).

11. The controller according to any one of claims 4 8-10, wherein the power management module (4) comprises a power management integrated circuit;
the first processor (2) comprises a field programmable gate array, and the second processor (3) comprises the field programmable gate array.

12. A driverless vehicle, comprising the controller for the driverless vehicle according to any one of claims 1-11.

13. The driverless vehicle according to claim 12, further comprising:
a camera module (9);
a motion measurement module (10);
an Ethernet communication module (11);
a controller area network communication module (12); and
a heat dissipation module (13),
wherein the camera module (9), the motion measurement module (10), the Ethernet communication module (11), the controller area network communication module (12) and the heat dissipation module (13) are coupled to the security micro control unit (1);
the security micro control unit (1) is configured to monitor a running state of each of the camera module (9), the motion measurement module (10), the Ethernet communication module (11), the controller area network communication module (12), and the heat dissipation module (13).

14. The driverless vehicle according to claim 12, further comprising:
a vehicle speed signal acquisition circuit (14);
a steering wheel angle signal acquisition circuit (15);
a brake signal acquisition circuit (16); and
a gear signal acquisition circuit (17),
wherein the vehicle speed signal acquisition circuit (14), the steering wheel angle signal acquisition circuit (15), the brake signal acquisition circuit (16) and the gear signal acquisition circuit (17) are coupled to the security micro control unit (1);
the security micro control unit (1) is configured to monitor a running state of each of the vehicle speed signal acquisition circuit (14), the steering wheel angle signal acquisition circuit (15), the brake signal acquisition circuit (16), and the gear signal acquisition circuit (17).

## Patentansprüche

1. Eine Steuervorrichtung für ein fahrerloses Fahrzeug, die folgende Merkmale aufweist:
eine Sicherheitsmikrosteuereinheit (1); und
ein Prozessormodul (M),
wobei das Prozessormodul mit der Sicherheitsmikrosteuereinheit (1) gekoppelt ist, und die Sicherheitsmikrosteuereinheit (1) dazu konfiguriert ist, einen Betriebszustand des Prozessormoduls (M) zu überwachen;
**dadurch gekennzeichnet, dass** die Steuervorrichtung ferner folgendes Merkmal aufweist:
ein Leistungsverwaltungsmodul (4), das mit der Sicherheitsmikrosteuereinheit (1) gekoppelt ist und dazu konfiguriert ist, einen Betriebszustand der Sicherheitsmikrosteuereinheit (1) zu überwachen;
wobei die Sicherheitsmikrosteuereinheit (1) dazu konfiguriert ist, einen Betriebszustand des Leistungsverwaltungsmoduls (4) zu überwachen.

2. Die Steuervorrichtung gemäß Anspruch 1, wobei das Prozessormodul (M) einen ersten Prozessor (2) und einen zweiten Prozessor (3) aufweist, wobei der erste Prozessor (2) und der zweite Prozessor (3) jeweils mit der Sicherheitsmikrosteuereinheit (1) gekoppelt sind;
die Sicherheitsmikrosteuereinheit (1) dazu konfiguriert ist, einen Betriebszustand sowohl des ersten Prozessors (2) als auch des zweiten Prozessors (3) zu überwachen.

3. Die Steuervorrichtung gemäß Anspruch 1 oder 2, die ferner folgende Merkmale aufweist:
eine Leistungsversorgung (5); und
ein Prozessor-Leistungsversorgungsteilsystem (6),
wobei das Prozessor-Leistungsversorgungsteilsystem (6) mit der Leistungsversorgung (5) und dem Prozessormodul (M) gekoppelt ist und dazu konfiguriert ist, dem Prozessormodul (M) eine Betriebsspannung auf Basis einer Leistungsversorgungsspannung bereitzustellen, die durch die Leistungsversorgung (5) ausgegeben wird,
die Sicherheitsmikrosteuereinheit (1) mit dem Prozessor-Leistungsversorgungsteilsystem (6) gekoppelt ist und dazu konfiguriert ist, einen Betriebszustand des Prozessor-Leistungsversorgungsteilsystem s (6) zu überwachen.

4. Die Steuervorrichtung gemäß Anspruch 2 und 3, die ferner folgende Merkmale aufweist:
ein Notfall-Leistungsversorgungsteilsystem (7), das mit der Leistungsversorgung (5) und dem Leistungsverwaltungsmodul (4) gekoppelt ist; wobei
die Stromversorgung (5) mit dem Leistungsverwaltungsmodul (4) gekoppelt ist;
das Notfall-Leistungsversorgungsteilsystem (7) dazu konfiguriert ist, dem Leistungsverwaltungsmodul (4) eine Betriebsspannung auf Basis einer vorgespeicherten Leistungsmenge bereitzustellen, wenn die Leistungsversorgung (5) ausfällt;
das Leistungsverwaltungsmodul (4) dazu konfiguriert ist, der Sicherheitsmikrosteuereinheit (1) eine Betriebsspannung auf Basis der von der Leistungsversorgung (5) ausgegebenen Leistungsversorgungsspannung bereitzustellen, wenn die Leistungsversorgung (5) nicht ausfällt, und der Sicherheitsmikrosteuereinheit (1) die Betriebsspannung auf Basis einer von dem Notfall-Leistungsversorgungsteilsystem (7) ausgegebenen Leistungsversorgungsspannung bereitzustellen, wenn die Leistungsversorgung (5) ausfällt; und
die Sicherheitsmikrosteuereinheit (1) dazu konfiguriert ist, den Betriebszustand sowohl des ersten Prozessors (2) als auch des zweiten Prozessors (3) auf Basis der von dem Leistungsverwaltungsmodul (4) bereitgestellten Betriebsspannung zu überwachen und eine Bereitschaftssteuervorrichtung zu starten, wenn der Betriebszustand des ersten Prozessors (2) oder des zweiten Prozessors (3) anormal ist.

5. Die Steuervorrichtung gemäß Anspruch 3 oder 4, wobei die Leistungsversorgung (5) eine Leistungsquelle (51), eine Haupt-Leistungsversorgungsschaltung und eine Bereitschafts-Leistungsversorgungsschaltung aufweist,
ein Eingangsende der Haupt-Leistungsversorgungsschaltung und ein Eingangsende der Bereitschafts-Leistungsversorgungsschaltung jeweils mit der Leistungsquelle (51) gekoppelt sind;
ein Ausgangsende der Haupt-Leistungsversorgungsschaltung mit einem Verbindungsknoten gekoppelt ist;
ein Ausgangsende der Bereitschafts-Leistungsversorgungsschaltung über eine Schaltkomponente (52) mit dem Verbindungsknoten verbunden ist;
der Verbindungsknoten mit dem Prozessor-Leistungsversorgungsteilsystem (6) und dem Notfall-Leistungsversorgungsteilsystem (7) gekoppelt ist;
die Schaltkomponente (52) dazu konfiguriert ist, eine Verbindung zwischen der Bereitschafts-Leistungsversorgungsschaltung und dem Verbindungsknoten umzuschalten, wenn die Haupt-Leistungsversorgungsschaltung ausfällt.

6. Die Steuervorrichtung gemäß Anspruch 5, wobei die Schaltkomponente (52) eine erste Diode aufweist, das Ausgangsende der Bereitschafts-Leistungsversorgungsschaltung mit einer Anode der ersten Diode gekoppelt ist und eine Kathode der ersten Diode mit dem Verbindungsknoten gekoppelt ist.

7. Die Steuervorrichtung gemäß Anspruch 5 oder 6, wobei die Haupt-Leistungsversorgungsschaltung einen ersten Verbinder (53), eine erste elektrostatische Schutzschaltung (54), eine erste Unterbrechungserfassungsschaltung (55) und eine Anti-Anti-Reverse-Schutzschaltung (56) aufweist,
ein Eingangsende des ersten Verbinders (53) mit der Leistungsquelle (51) gekoppelt ist;
die erste elektrostatische Schutzschaltung (54) und die erste Unterbrechungserfassungsschaltung (55) jeweils mit einem Ausgangsende des ersten Verbinders (53) verbunden sind;
die Anti-Reverse-Schutzschaltung (56) mit der ersten elektrostatischen Schutzschaltung (54) gekoppelt ist und die Anti-Reverse-Schutzschaltung (56) ferner mit dem Verbindungsknoten gekoppelt ist; und
die Sicherheitsmikrosteuereinheit (1) mit der ersten Unterbrechungserfassungsschaltung (55) gekoppelt ist und dazu konfiguriert ist, einen Betriebszustand der ersten Unterbrechungserfassungsschaltung (55) zu überwachen.

8. Die Steuervorrichtung gemäß Anspruch 5 oder 6, wobei die Bereitschafts-Leistungsversorgungsschaltung einen zweiten Verbinder (57), eine zweite elektrostatische Schutzschaltung (58) und eine zweite Unterbrechungserfassungsschaltung (59) aufweist,
ein Eingangsende des zweiten Verbinders (57) mit der Leistungsquelle (51) gekoppelt ist;
die zweite elektrostatische Schutzschaltung (58) mit einem Ausgangsende des zweiten Verbinders (57) gekoppelt ist;
die Anode der ersten Diode mit der zweiten elektrostatischen Schutzschaltung (58) gekoppelt ist;
die zweite Unterbrechungserfassungsschaltung (59) mit der Kathode der ersten Diode gekoppelt ist; und
die Sicherheitsmikrosteuereinheit (1) mit der zweiten Unterbrechungserfassungsschaltung (59) gekoppelt ist und dazu konfiguriert ist, einen Betriebszustand der zweiten Unterbrechungserfassungsschaltung (59) zu überwachen.

9. Die Steuervorrichtung gemäß nach einem der Ansprüche 3 bis 6, wobei die Leistungsversorgung (5) eine Spannungsfilterschaltung (67) aufweist,
ein Eingangsende der Spannungsfilterschaltung (67) mit dem Verbindungsknoten gekoppelt ist; und
ein Ausgangsende der Spannungsfilterschaltung (67) mit dem Prozessor-Leistungsversorgungsteilsystem (6) gekoppelt ist,
das Notfall-Leistungsversorgungsteilsystem (7) und das Leistungsverwaltungsmodul (4) gekoppelt sind.

10. Die Steuervorrichtung gemäß einem der Ansprüche 3 bis 9, wobei das Leistungsverwaltungsmodul (4) eine Sicherheitskanalsignalquelle (SS1, SS2) aufweist, wobei die Sicherheitskanalsignalquelle (SS1, SS2) mit der Sicherheitsmikrosteuereinheit (1) und einer Bereitschaftssteuervorrichtung (8) gekoppelt ist;
das Leistungsverwaltungsmodul (4) dazu konfiguriert ist, die Sicherheitskanalsignalquelle (SS1, SS2) zu triggern, um ein Sicherheitskanalsignal an die Bereitschaftssteuervorrichtung (8) zum Starten der Bereitschaftssteuervorrichtung (8) zu senden, wenn überwacht wird, dass ein Sicherheitsfehler in der Sicherheitsmikrosteuereinheit (1) auftritt;
die Sicherheitsmikrosteuereinheit (1) dazu konfiguriert ist, die Sicherheitskanalsignalquelle (SS1, SS2) zu triggern, um ein Sicherheitskanalsignal an die Bereitschaftssteuervorrichtung (8) zum Starten der Bereitschaftssteuervorrichtung (8) zu senden, wenn überwacht wird, dass der Sicherheitsfehler in dem ersten Prozessor (2) oder dem zweiten Prozessor (3) auftritt.

11. Die Steuervorrichtung gemäß einem der Ansprüche 4 bis 10, wobei das Leistungsverwaltungsmodul (4) eine integrierte Leistungsverwaltungsschaltung aufweist;
der erste Prozessor (2) ein feldprogrammierbares Gatterarray aufweist und der zweite Prozessor (3) das feldprogrammierbare Gatterarray aufweist.

12. Ein fahrerloses Fahrzeug, das die Steuervorrichtung für das fahrerlose Fahrzeug gemäß einem der Ansprüche 1 bis 11 aufweist.

13. Das fahrerlose Fahrzeug gemäß Anspruch 12, das ferner folgende Merkmale aufweist:
ein Kameramodul (9);
ein Bewegungsmessungsmodul (10);
ein Ethernet-Kommunikationsmodul (11);
ein Controller-Area-Network-Kommunikationsmodul (12); und
ein Wärmeableitungsmodul (13),
wobei das Kameramodul (9), das Bewegungsmessungsmodul (10), das Ethernet-Kommunikationsmodul (11), das Controller-Area-Network-Kommunikationsmodul (12) und das Wärmeableitungsmodul (13) mit der Sicherheitsmikrosteuereinheit (1) gekoppelt sind;
die Sicherheitsmikrosteuereinheit (1) dazu konfiguriert ist, einen Betriebszustand jedes des Kameramoduls (9), des Bewegungsmessungsmoduls (10), des Ethernet-Kommunikationsmoduls (11), des Controller-Area-Network-Kommunikationsmoduls (12) und des Wärmeableitungsmoduls (13) zu überwachen.

14. Das fahrerlose Fahrzeug gemäß Anspruch 12, das ferner folgende Merkmale aufweist:
eine Fahrzeuggeschwindigkeitssignal-Erfassungsschaltung (14);
eine Lenkradwinkelsignal-Erfassungsschaltung (15);
eine Bremssignal-Erfassungsschaltung (16); und
eine Getriebesignal-Erfassungsschaltung (17),
wobei die Fahrzeuggeschwindigkeitssignal-Erfassungsschaltung (14), die Lenkradwinkelsignal-Erfassungsschaltung (15), die Bremssignal-Erfassungsschaltung (16) und die Getriebesignal-Erfassungsschaltung (17) mit der Sicherheitsmikrosteuereinheit (1) gekoppelt sind;
die Sicherheitsmikrosteuereinheit (1) dazu konfiguriert ist, einen Betriebszustand jeder der Schaltung zur Erfassung von Fahrzeuggeschwindigkeitssignalen (14), der Schaltung zur Erfassung von Lenkradwinkelsignalen (15), der Schaltung zur Erfassung von Bremssignalen (16) und der Schaltung zur Erfassung von Getriebesignalen (17) zu überwachen.

## Revendications

1. Organe de commande pour un véhicule sans conducteur, comprenant:
une micro-unité de commande de sécurité (1); et
un module de processeur (M),
dans lequel le module de processeur est couplé à la micro-unité de commande de sécurité (1), et la micro-unité de commande de sécurité (1) est configurée pour surveiller un état de fonctionnement du module de processeur (M);
**caractérisé par le fait que** l'organe de commande comprend par ailleurs:
un module de gestion d'alimentation de courant (4) couplé à la micro-unité de commande de sécurité (1) et configuré pour surveiller un état de fonctionnement de la micro-unité de commande de sécurité (1);
dans lequel la micro-unité de commande de sécurité (1) est configurée pour surveiller un état de fonctionnement du module de gestion d'alimentation de courant (4).

2. Organe de commande selon la revendication 1, dans lequel le module de processeur (M) comprend un premier processeur (2) et un deuxième processeur (3), le premier processeur (2) et le deuxième processeur (3) sont couplés respectivement à la micro-unité de commande de sécurité (1);
la micro-unité de commande de sécurité (1) est configurée pour surveiller un état de fonctionnement de chacun du premier processeur (2) et du deuxième processeur (3).

3. Organe de commande selon la revendication 1 ou 2, comprenant par ailleurs:
une alimentation de courant (5); et
un sous-système d'alimentation de courant du processeur (6),
dans lequel le sous-système d'alimentation de courant du processeur (6) est couplé à l'alimentation de courant (5) et au module de processeur (M), et est configuré pour fournir une tension de fonctionnement au module de processeur (M) sur base d'une tension d'alimentation de courant sortie par l'alimentation de courant (5),
la micro-unité de commande de sécurité (1) est couplée au sous-système d'alimentation de courant du processeur (6) et est configurée pour surveiller un état de fonctionnement du sous-système d'alimentation de courant du processeur (6).

4. Organe de commande selon les revendications 2 et 3, comprenant par ailleurs:
un sous-système d'alimentation de courant de secours (7) couplé à l'alimentation de courant (5) et au module de gestion d'alimentation de courant (4);
dans lequel
l'alimentation de courant (5) est couplée au module de gestion d'alimentation de courant (4);
le sous-système d'alimentation de courant de secours (7) est configuré pour fournir une tension de fonctionnement au module de gestion d'alimentation de courant (4) sur base d'une quantité de courant pré-accumulée lorsque l'alimentation de courant (5) est défaillante;
le module de gestion de l'alimentation de courant (4) est configuré pour fournir une tension de fonctionnement à la micro-unité de commande de sécurité (1) sur base de la tension d'alimentation de courant sortie par l'alimentation de courant (5) lorsque l'alimentation de courant (5) n'est pas défaillante, et pour fournir la tension de fonctionnement à la micro-unité de commande de sécurité (1) sur base d'une tension d'alimentation de courant sortie par le sous-système d'alimentation de courant de secours (7) lorsque l'alimentation de courant (5) est défaillante; et
la micro-unité de commande de sécurité (1) est configurée pour surveiller l'état de fonctionnement de chacun parmi le premier processeur (2) et le deuxième processeur (3) sur base de la tension de fonctionnement fournie par le module de gestion d'alimentation de courant (4), et pour mettre en marche un organe de commande de secours lorsque l'état de fonctionnement du premier processeur (2) ou du deuxième processeur (3) est anormal.

5. Organe de commande selon la revendication 3 ou 4, dans lequel l'alimentation de courant (5) comprend une source de courant (51), un circuit d'alimentation de courant principal et un circuit d'alimentation de courant de secours,
une extrémité d'entrée du circuit d'alimentation de courant principal et une extrémité d'entrée du circuit d'alimentation de courant de secours sont couplées respectivement à la source de courant (51);
une extrémité de sortie du circuit d'alimentation de courant principal est couplée à un nœud commun;
une extrémité de sortie du circuit d'alimentation de courant de secours est couplée au nœud commun par l'intermédiaire d'un composant de commutation (52);
le nœud commun est couplé au sous-système d'alimentation de courant du processeur (6) et au sous-système d'alimentation de courant de secours (7);
le composant de commutation (52) est configuré pour activer une connexion entre le circuit d'alimentation de courant de secours et le nœud commun lorsque le circuit d'alimentation de courant principal est défaillant.

6. Organe de commande selon la revendication 5, dans lequel le composant de commutation (52) comprend une première diode, l'extrémité de sortie du circuit d'alimentation de courant de secours est couplée à une anode de la première diode, et une cathode de la première diode est couplée au nœud commun.

7. Organe de commande selon la revendication 5 ou 6, dans lequel le circuit d'alimentation de courant principal comprend un premier connecteur (53), un premier circuit de protection électrostatique (54), un premier circuit de détection d'interruption (55), et un circuit de protection anti-retour (56),
une extrémité d'entrée du premier connecteur (53) est couplée à la source de courant (51);
le premier circuit de protection électrostatique (54) et le premier circuit de détection d'interruption (55) sont couplés respectivement à une extrémité de sortie du premier connecteur (53);
le circuit de protection anti-retour (56) est couplé au premier circuit de protection électrostatique (54), et le circuit de protection anti-retour (56) est par ailleurs couplé au nœud commun; et
la micro-unité de commande de sécurité (1) est couplée au premier circuit de détection d'interruption (55) et configurée pour surveiller un état de fonctionnement du premier circuit de détection d'interruption (55).

8. Organe de commande selon la revendication 5 ou 6, dans lequel le circuit d'alimentation de courant de secours comprend un deuxième connecteur (57), un deuxième circuit de protection électrostatique (58) et un deuxième circuit de détection d'interruption (59),
une extrémité d'entrée du deuxième connecteur (57) est couplée à la source de courant (51);
le deuxième circuit de protection électrostatique (58) est couplé à une extrémité de sortie du deuxième connecteur (57);
l'anode de la première diode est couplée au deuxième circuit de protection électrostatique (58);
le deuxième circuit de détection d'interruption (59) est couplé à la cathode de la première diode; et
la micro-unité de commande de sécurité (1) est couplée au deuxième circuit de détection d'interruption (59) et est configurée pour surveiller un état de fonctionnement du deuxième circuit de détection d'interruption (59).

9. Organe de commande selon l'une quelconque des revendications 3 à 6, dans lequel l'alimentation de courant (5) comprend un circuit de filtrage de tension (67),
une extrémité d'entrée du circuit de filtrage de tension (67) est couplée au nœud commun; et
une extrémité de sortie du circuit de filtrage de tension (67) est couplée au sous-système d'alimentation de courant du processeur (6), au sous-système d'alimentation de courant de secours (7) et au module de gestion de courant (4).

10. Organe de commande selon l'une quelconque des revendications 3 à 9, dans lequel le module de gestion de courant (4) comprend une source de signal de canal de sécurité (SS1, SS2), la source de signal de canal de sécurité (SS1, SS2) est couplée à la micro-unité de commande de sécurité (1) et à un organe de commande de secours (8);
le module de gestion de courant (4) est configuré pour déclencher la source de signal de canal de sécurité (SS1, SS2) pour envoyer un signal de canal de sécurité à l'organe de commande de secours (8) pour mettre en marche l'organe de commande de secours (8) lors de la surveillance de s'il se produit un défaut de sécurité dans la micro-unité de commande de sécurité (1);
la micro-unité de commande de sécurité (1) est configurée pour déclencher la source de signal de canal de sécurité (SS1, SS2) pour envoyer un signal de canal de sécurité à l'organe de commande de secours (8) pour mettre en marche l'organe de commande de secours (8) lors de la surveillance de s'il se produit le défaut de sécurité dans le premier processeur (2) ou le deuxième processeur (3).

11. Organe de commande selon l'une quelconque des revendications 4 à 10, dans lequel le module de gestion de courant (4) comprend un circuit intégré de gestion de courant;
le premier processeur (2) comprend un réseau de portes programmable par l'utilisateur, et le deuxième processeur (3) comprend le réseau de portes programmable par l'utilisateur.

12. Véhicule sans conducteur, comprenant l'organe de commande pour le véhicule sans conducteur selon l'une quelconque des revendications 1 à 11.

13. Véhicule sans conducteur selon la revendication 12, comprenant par ailleurs:
un module de caméra (9);
un module de mesure de mouvement (10);
un module de communication Ethernet (11);
un module de communication de réseau de zone de l'organe de commande (12); et
un module de dissipation thermique (13),
dans lequel le module de caméra (9), le module de mesure de mouvement (10), le module de communication Ethernet (11), le module de communication de réseau de zone de l'organe de commande (12) et le module de dissipation thermique (13) sont couplés à la micro-unité de commande de sécurité (1);
la micro-unité de commande de sécurité (1) est configurée pour surveiller un état de fonctionnement de chacun parmi le module de caméra (9), le module de mesure de mouvement (10), le module de communication Ethernet (11), le module de communication de réseau de zone de l'organe de commande (12) et le module de dissipation thermique (13).

14. Véhicule sans conducteur selon la revendication 12, comprenant par ailleurs:
un circuit d'acquisition de signal de vitesse de véhicule (14);
un circuit d'acquisition de signal d'angle de volant (15);
un circuit d'acquisition de signal de frein (16); et
un circuit d'acquisition de signal d'engrenage (17),
dans lequel le circuit d'acquisition de signal de vitesse de véhicule (14), le circuit d'acquisition de signal d'angle de volant (15), le circuit d'acquisition de signal de frein (16) et le circuit d'acquisition de signal d'engrenage (17) sont couplés à la micro-unité de commande de sécurité (1);
l'unité de microcommande de sécurité (1) est configurée pour surveiller un état de fonctionnement de chacun parmi le circuit d'acquisition de signal de vitesse de véhicule (14), le circuit d'acquisition de signal d'angle de volant (15), le circuit d'acquisition de signal de frein (16) et le circuit d'acquisition de signal d'engrenage (17).
